(19) Europäisches Patentamt
European Patent Office
Office européen des brevets

(11) **EP 4 315 288 B1**

(12) **EUROPÄISCHE PATENTSCHRIFT**

(45) Veröffentlichungstag und Bekanntmachung des Hinweises auf die Patenterteilung:
**25.02.2026   Patentblatt 2026/09**

(21) Anmeldenummer: **22717525.4**

(22) Anmeldetag: **22.03.2022**

(51) Internationale Patentklassifikation (IPC):
**G07D 7/04** *(2016.01)*          **G01R 33/345** *(2006.01)*
**G01R 33/60** *(2006.01)*          **G01R 33/30** *(2006.01)*
**G01N 24/10** *(2006.01)*

(52) Gemeinsame Patentklassifikation (CPC):
**G07D 7/04; G01N 24/10; G01R 33/3456; G01R 33/60;** G01R 33/307

(86) Internationale Anmeldenummer:
**PCT/EP2022/025115**

(87) Internationale Veröffentlichungsnummer:
**WO 2022/199891 (29.09.2022 Gazette 2022/39)**

(54) **SENSORELEMENT, PRÜFVORRICHTUNG UND VERFAHREN FÜR DIE PRÜFUNG VON DATENTRÄGERN MIT EINEM SPINRESONANZ-MERKMAL**

SENSOR ELEMENT, TEST DEVICE AND METHOD FOR TESTING DATA CARRIERS HAVING A SPIN RESONANCE FEATURE

ÉLÉMENT CAPTEUR, DISPOSITIF DE TEST ET PROCÉDÉ DE TEST DE SUPPORTS DE DONNÉES AYANT UNE CARACTÉRISTIQUE DE RÉSONANCE DE SPIN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.03.2021   DE 102021001593**

(43) Veröffentlichungstag der Anmeldung:
**07.02.2024   Patentblatt 2024/06**

(73) Patentinhaber: **Giesecke+Devrient Currency Technology GmbH**
**81677 München (DE)**

(72) Erfinder: **HUBER, Stephan**
**80634 München (DE)**

(74) Vertreter: **Giesecke+Devrient IP**
**Prinzregentenstraße 161**
**81677 München (DE)**

(56) Entgegenhaltungen:
**US-A- 5 149 946     US-A1- 2005 270 023**

• **ELLERSIEK DENNIS: "Entwicklung und Charakterisierung von mikrostrukturierten Planarspulen für Kernspinresonanz-Anwendungen", 1 January 2010 (2010-01-01), XP055936872, Retrieved from the Internet <URL:http://publications.rwth-aachen.de/record/51600/files/Ellersiek_Dennis.pdf> [retrieved on 20220629]**
• **RIZWAN AHMAD ET AL: "Theory, Instrumentation, and Applications of Electron Paramagnetic Resonance Oximetry", CHEMICAL REVIEWS, vol. 110, no. 5, 12 May 2010 (2010-05-12), US, pages 3212 - 3236, XP055441105, ISSN: 0009-2665, DOI: 10.1021/cr900396q**

**Beschreibung**

Die Erfindung betrifft ein Sensorelement für die Prüfung eines flächigen Datenträgers, insbesondere einer Banknote, mit einem Spinresonanz-Merkmal. Die Erfindung betrifft auch eine Prüfvorrichtung mit einem solchen Sensorelement und ein Verfahren zur Prüfung mit einem solchen Sensorelement.

Datenträger, wie Wert- oder Ausweisdokumente, aber auch andere Wertgegenstände, wie etwa Markenartikel, werden zur Absicherung oft mit Sicherheitselementen versehen, die eine Überprüfung der Echtheit der Datenträger gestatten und die zugleich als Schutz vor unerlaubter Reproduktion dienen. Es ist bekannt, bei der maschinellen Echtheitsprüfung Sicherheitselemente mit Spinresonanz-Merkmalen zur Absicherung von Dokumenten und anderen Datenträgern einzusetzen. Die Sicherheitselemente sind dazu mit Substanzen versehen, die eine Spinresonanz-Signatur aufweisen.

Spinresonanz-Merkmale beruhen allgemein auf einer resonanten Energieabsorption eines Spin-Ensembles in einem äußeren Magnetfeld. Physikalisch liegt der resonanten Energieabsorption die Aufspaltung der Energiezustände des Spin-Ensembles im äußeren Magnetfeld zugrunde. Spins, deren magnetische Momente parallel zu dem äußeren Feld orientiert sind, haben einen niedrigeren Energiezustand als Spins mit einem antiparallelen magnetischen Moment. Durch das Einstrahlen eines magnetischen Wechselfeldes passender Stärke, das senkrecht zu dem als Polarisationsfeld bezeichneten, äußeren Magnetfeld orientiert ist, können resonant Übergänge zwischen den Energieniveaus angeregt werden.

Die zur Anregung der Übergange notwendige Resonanzfrequenz bzw. Larmorfrequenz $f_L$ ist durch die Energiedifferenz der aufgespaltenen Niveaus gegeben,

$$2\pi f_L = \gamma\, B_c,$$

wobei $\gamma$ das gyromagnetische Verhältnis der beteiligten Spins angibt und $B_c$ das relevante charakteristische Magnetfeld bezeichnet.

Zur Echtheitsabsicherung können in Sicherheitselementen als Spin-Ensembles sowohl Kernspins als auch Elektronspins genutzt werden, man spricht bei der resonanten Anregung entsprechend von Kernspin-Resonanz (Nuclear Magnetic Resonance, NMR) oder von Elektronspin-Resonanz (ESR). Auch Materialien mit hoher Elektronenspindichte, bei denen die Wechselwirkung der Spins untereinander nicht mehr zu vernachlässigen ist, können eingesetzt werden. Hierzu zählen ferro- und ferrimagnetische Materialien und man spricht in diesen Fällen allgemein von ferromagnetischer Resonanz (FMR).

Bei der NMR und ESR ist das relevante charakteristische Magnetfeld $B_c$ im Wesentlichen durch das äußere Magnetfeld $B_0$ gegeben, bei der FMR hängt die Resonanzbedingung auch von im Material vorliegenden inneren Feldern ab, die zusammen mit dem äußeren Magnetfeld ein effektives Feld $B_{eff}$ bilden, das dann das für die Berechnung der Resonanzfrequenz relevante charakteristische Magnetfeld $B_c$ darstellt.

Bei üblichen Magnetfeldstärken liegt bei der NMR die Resonanzfrequenz typischerweise im MHz-Bereich, bei der ESR und FMR typischerweise deutlich höher im GHz-Bereich.

Die genannten Spinresonanzen können beispielsweise in einem Dauerstrich (CW)-Verfahren gemessen werden, bei dem eine Signalquelle bei einer festen Anregungsfrequenz $f_L$ betrieben wird, die der erwarteten Larmorfrequenz des Spinresonanz-Merkmals entspricht, und bei dem dem Polarisationsfeld ein paralleles zeitabhängiges Modulationsfeld überlagert ist. Manche Spinresonanz-Effekte könne auch in einem gepulsten Verfahren gemessen werden, bei dem die Besetzungszustände durch resonante Einzelpulse oder Pulssequenzen des Hochfrequenzsignals manipuliert werden. Auch weitere spezielle Verfahren, wie etwa das Rapid-Scan-Verfahren, bei dem bei stark erhöhtem Hochfrequenzfeld $B_1$ das Polarisationsfeld $B_0$ so schnell durchfahren wird, dass keine Sättigung der Spinzustände eintritt, können zum Einsatz kommen.

Unabhängig vom eingesetzten Messverfahren ist das Signal-zu-Rausch-Verhältnis einer Spinresonanz-Messung immer durch das erste Glied der Hochfrequenzkette, also durch den Resonator, dominiert. Das am Resonatoranschluss abgreifbare, für die Spinresonanz charakteristische Hochfrequenzsignal S ist dabei insbesondere proportional zum Füllfaktor $\eta$ des Resonators, zur Resonatorgüte Q und zur Anzahl der Partikel $N_S$ im sensitiven Bereich,

$$S \sim \eta * Q * N_S,$$

wobei der Füllfaktor $\eta$ das Verhältnis der im Proben-Volumen gespeicherten magnetischen Feldenergie zu der gesamten im Raum gespeicherten magnetischen Feldenergie des Resonators angibt.

US 5149946 A betrifft ein Verfahren zur Authentifizierung eines Objekts durch Elektronenspinresonanzspektroskopie. Bei dem Verfahren wird dem Objekt mindestens eine Authentifizierungssubstanz zugesetzt, die einen EPR-Peak aufweist, dessen Breite nicht größer als etwa 1,5 Gauß ist. Die Spektroskopie wird in einem statischen Feld mit einer solchen Amplitude durchgeführt, dass die Substanz eine Resonanzfrequenz im Radiofrequenzbereich aufweist. Die Breite des EPR-Peaks der Substanz wird als Unterscheidungskriterium verwendet. Dem statischen Feld wird vorzugsweise ein niederfrequentes kollineares Modulationsfeld überlagert, dessen Amplitude wesentlich größer ist als die EPR-Breite der Substanz. Unter einem elektromagnetischen Radiofrequenzfeld, das senkrecht zum statischen Feld und zum Modulationsfeld verläuft und eine Amplitude aufweist, die nicht kleiner ist als die Peak-Breite, werden paramagnetische Materialien mit einer Peak-Breite, die größer ist als die der authentifizierenden Substanz, nicht erkannt. Offenbart ist außerdem eine Vorrichtung zur Durchführung des Verfahrens sowie ein mit dem Verfahren verwendbares Sicherheitspapier.

Ausgehend davon liegt der Erfindung die Aufgabe zugrunde, eine verbesserte Vorrichtung für die Prüfung von Datenträgern mit Spinresonanz-Merkmalen anzugeben, welche insbesondere eine Prüfung an schnell-laufenden Datenträgern im CW-Verfahren und/oder in einem gepulsten Verfahren und/ oder in einem Rapid-Scan Verfahren erlaubt.

Diese Aufgabe wird durch die Merkmale der unabhängigen Ansprüche gelöst. Weiterbildungen der Erfindung sind Gegenstand der abhängigen Ansprüche.

Die Erfindung stellt ein Sensorelement für die Prüfung, insbesondere Echtheitsprüfung, eines flächigen Datenträgers mit einem Spinresonanz-Merkmal bereit. Bei dem flächigen Datenträger kann es sich beispielsweise um eine Banknote handeln. Das Sensorelement umfasst einen Magnetkern mit einem Luftspalt, in den der flächige Datenträger zur Prüfung einbringbar ist, ein Element zu Erzeugung eines statischen magnetischen Flusses in dem Luftspalt, und einen Resonator zur Anregung des Spinresonanz-Merkmals des zu prüfenden Datenträgers.

Vorzugsweise umfasst das Sensorelement weiterhin eine Modulationseinrichtung zur Erzeugung eines modulierten Magnetfelds parallel zu dem statischen magnetischen Fluss im Luftspalt. Diese Modulation kann beispielsweise mit einer Frequenz zwischen etwa 1 kHz und etwa 1 MHz erfolgen. Dies ermöglicht eine Spin-Resonanz-Messung mit gutem Signal-zu-Rausch-Verhältnis.

Als Besonderheit ist der Resonator durch einen in dem Luftspalt des Magnetkerns angeordneten Streifenleitungs-Resonator gebildet, welcher einen flächigen Träger mit einer Oberseite und einer gegenüberliegenden Unterseite aufweist, und eine auf der Oberseite des Trägers angeordnete leitende Struktur mit einer charakteristischen Länge l.

Vorzugsweise weist der flächige Träger auf der Oberseite und/oder der Unterseite eine Masserückführung auf. Bevorzugt ist die Masserückführung als Massefläche ausgebildet. Die Massefläche ist vorzugsweise auf der Unterseite des Trägers ausgebildet, was eine zuverlässigere Messung des Spinresonanz-Signals auch bei Vorliegen von äußeren Störsignalen ermöglicht.

Der Streifenleitungs-Resonator bildet in bevorzugten Gestaltungen eine $\lambda/4$-Grundmode, eine $\lambda/2$-Grundmode oder eine $\lambda$-Grundmode aus. Dies bedeutet, dass die räumliche Ausdehnung des B1-Feldes etwa einem Viertel der - bzw. der Hälfte der, bzw. der ganzen - Wellenlänge $\lambda$ des eingekoppelten Hochfrequenzsignals entspricht. Ein Resonator mit einer $\lambda/4$-Grundmode ist dann vorteilhaft, wenn eine geringe Bauform bzw. Baugröße des Resonators gewünscht ist. Einher mit der geringen Baugröße geht eine räumlich betrachtet kleine $B_1$-Verteilung bei gleichzeitig hoher Ortsauflösung und niedriger Anzahl der gemessenen Partikel $N_S$. Ein Resonator mit einer $\lambda$-Grundmode weist dagegen eine größere Bauform und eine größere Ausdehnung des $B_1$-Feldes auf, also eine geringere Ortsauflösung, aber eine hohe Anzahl der gemessenen Partikel $N_S$. Ein Resonator mit $\lambda/2$-Grundmode ist ein Kompromiss aus den beiden vorher genannten Typen.

Zweckmäßig umfasst der Streifenleitungs-Resonator als leitende Struktur eine Rechteckstruktur, eine Ringstruktur mit kreisförmiger oder elliptischer Außenkontur, eine scheibenförmige Struktur, eine Ringsektoren-Struktur mit kreisförmigen oder elliptischen Außenkanten, oder eine Struktur mit einer Dreieck- oder Vieleckform. Besonders bevorzugt sind Rechteck-, Ring- und Scheibenstrukturen, da innerhalb dieser Strukturen eine definierte Resonanzmode und damit auch eine definierte $B_1$-Verteilung auf einfache Art und Weise angeregt werden kann. Alternative Geometrien können hingegen bei spezifischen Leiterplattendesigns vorteilhaft auf Grund ihrer geringen Baugröße sein. Auch Kombinationen der genannten Elemente können als leitende Struktur verwendet werden.

Der Streifenleitungs-Resonator ist vorteilhaft mit seiner charakteristischen Länge l auf die Prüfung des Spinresonanz-Merkmals des Datenträgers in der räumlichen Grundmode des Anregungsfelds eingerichtet. Dies ermöglicht eine besonders geringe Baugröße des Streifenleitungs-Resonators. Als besonders vorteilhaft hat sich auch herausgestellt, wenn der Streifenleitungs-Resonator mit seiner charakteristischen Länge l auf die Prüfung des Spinresonanz-Merkmals des Datenträgers in einer höheren räumlichen Mode des Anregungsfelds, insbesondere der zweiten oder dritten Mode des Anregungsfelds, ausgelegt und eingerichtet ist. Dies ermöglicht die Messung in einem größeren Probenvolumen und damit eine Erhöhung der Anzahl $N_S$ der Partikel im sensitiven Bereich.

In einer vorteilhaften Ausgestaltung weist der Streifenleitungs-Resonator eine Güte Q zwischen 50 und 400, insbesondere zwischen 80 und 300 auf.

Der Streifenleitungs-Resonator enthält vorteilhaft zumindest einen Signalleiter, an den die leitende Struktur gekoppelt ist. In einer vorzugsweisen Ausführungsform umfasst der Streifenleitungs-Resonator genau einen Signalleiter und wird in Reflexion betrieben. In einer weiteren vorzugsweisen Ausführungsform umfasst der Streifenleitungs-Resonator genau zwei Signalleiter und wird in Transmission betrieben. Vorzugsweise sind der oder die Signalleiter auf der Oberseite des Trägers angeordnet, was die Herstellung des Streifenleitungs-Resonators vereinfacht. In diesem Fall erfolgt die Kopplung des bzw. der Signalleiter an die leitende Struktur vorzugsweise kapazitiv oder über einen Inset-Feed. Beim Inset-Feed befindet sich der Signalleiter und der Resonator insbesondere auf der selben Ebene. Der Ankoppelpunkt zwischen Signalleiter und Resonator befindet sich vorzugsweise aber nicht an der Kante des Resonators, sondern innerhalb der metallisierten Kupferfläche des Resonators. Mit einem solchen Vorgehen können unerwünschte Signalreflexionen zwischen Signalleiter und Resonator unterdrückt werden.

Auch eine Anordnung eines oder mehrerer Signalleiter auf der Unterseite des Trägers ist möglich. In diesem Fall kann beispielsweise eine sogenannte Apertur-Kopplung oder eine koaxiale Kopplung zur Ankopplung der leitenden Struktur an den bzw. die Signalleiter eingesetzt werden. Die Anordnung auf der Unterseite ermöglicht geringe parasitäre Streuverluste und eine Signal-Ankopplung, die unabhängig von der Beladung des Streifenleitungs-Resonators mit einem Prüfling ist.

Der Resonator ist dabei vorzugsweise in einem Frequenzbereich zwischen 1 GHz und 100 GHz resonant. Besonders bevorzugt ist ein Frequenzbereich zwischen 5 GHz und 85 GHz, insbesondere zwischen 15 GHz und 50 GHz. Gegenüber niedrigeren Frequenzen ermöglicht dies eine höhere spektrale Auflösung und ein stärkeres Messsignal.

Der Träger des Streifenleitungs-Resonators ist mit Vorteil durch eine Leiterplatte gebildet, was eine reproduzierbare und kostengünstige Herstellung erlaubt. Es ist allerdings auch vorteilhaft, insbesondere zur Verringerung dielektrischer Verluste im Trägermaterial, Träger auf Basis von Keramik, Teflon oder Kohlenwasserstoffen einzusetzen.

In einer vorteilhaften Ausgestaltung ist die leitende Struktur des Streifenleitungs-Resonators durch eine Silberschicht gebildet oder durch einen Leiter, beispielsweise aus Kupfer, der mit einer Silberbeschichtung sowie einer geeigneten Schutzschicht versehen ist. Auf Grund der gegenüber Kupfer besseren Leitfähigkeit von Silber ermöglicht dies eine höhere Resonatorgüte Q. Da wegen des Skin-Effekts die Stromdichte im Randbereich des Signalleiters höher ist, kann die Resonatorgüte schon durch eine Silberbeschichtung erhöht werden.

In einer weiteren vorteilhaften Ausgestaltung hat die leitende Struktur des Streifenleitungsresonators eine geringe Oberflächenrauigkeit. Bevorzugt ist eine Oberflächenrauigkeit Rq kleiner als 2,9 $\mu$m, besonders bevorzugt kleiner als 0,9 $\mu$m, insbesondere kleiner als 0,4 $\mu$m. Die Reduzierung der Oberflächenrauigkeit ermöglicht eine hohe Resonatorgüte Q.

In einer vorteilhaften Weiterbildung der Erfindung ist der Streifenleitungs-Resonator in dem Luftspalt parallel und beabstandet zu einem metallisierten Schirmelement angeordnet, um Abstrahlverluste des Resonators zu reduzieren. Das Schirmelement weist vorteilhaft einen Träger auf, beispielsweise eine Leiterplatte, der mit einer Metallisierung versehen ist. Dies ist fertigungstechnisch vorteilhaft. Weiterhin kann die Leiterplatte dann auch die Vorrichtung zur Erzeugung des Modulationsfeldes, beispielsweise mittels Planar-Spulen, umfassen. Der Streifenleitungs-Resonator und das Schirmelement bilden zweckmäßig einen schmalen Schlitz aus, in dem ein Transportpfad für die zu prüfenden Datenträger verläuft.

Bei dem Spinresonanz-Merkmal des zu prüfenden Datenträgers kann es sich um ein Kernspin-Resonanz-Merkmal, ein Elektronspin-Resonanz-Merkmal oder ein ferromagnetisches bzw. ferrimagnetisches Resonanz-Merkmal handeln. Besonders vorteilhaft ist das Sensorelement für die Prüfung eines Elektronspin-Resonanz-Merkmals oder eines ferromagnetischen bzw. ferrimagnetischen Resonanz-Merkmals ausgelegt und eingerichtet, da bei diesen besonders hohe Resonanzfrequenzen auftreten.

Das Element zur Erzeugung eines statischen magnetischen Flusses ist vorteilhaft durch einen Permanentmagneten gebildet. Dies reduziert gegenüber einem Aufbau, bei dem der statische Anteil des magnetischen Flusses durch einen Elektromagneten erzeugt wird, den Energieverbrauch und die Abwärme. Es kann in anderen Gestaltungen allerdings auch vorteilhaft sein, nicht nur einen zeitveränderlichen Anteil, nämlich das Modulationsfeld, sondern auch den statischen Anteil des magnetischen Flusses im Luftspalt mittels Elektromagneten zu erzeugen. Dies ermöglicht nach dem Abschalten des Sensorelements eine besonders einfache Handhabung, insbesondere beim Aufbau, der Zerlegung und dem Transport der Prüfvorrichtung.

Die Erfindung enthält auch eine Prüfvorrichtung für die Prüfung, insbesondere Echtheitsprüfung, flächiger Datenträger, insbesondere Banknoten, mit einem Sensorelement der beschriebenen Art. Die Prüfvorrichtung weist daneben eine Transporteinrichtung auf, die die zu prüfenden flächigen Datenträger entlang eines Transportpfades in den Luftspalt des Magnetkerns einbringt bzw. durch den Luftspalt des Magnetkerns hindurchführt.

Die Transporteinrichtung ist mit besonderem Vorteil auf einen schnell-laufenden Transport beispielsweise mit einer Geschwindigkeit von 1 bis 12 m/s der zu prüfenden flächigen Datenträger entlang des Transportpfades ausgelegt und eingerichtet.

Zweckmäßig ist die Transporteinrichtung ausgelegt und eingerichtet, die zu prüfenden flächigen Datenträger entlang eines Transportpfades in geringem Abstand über die Oberseite des Streifenleitungs-Resonators zu führen. Ein geringer Abstand ist dabei insbesondere ein Abstand von einigen Zehntel Millimetern, vorzugsweise von weniger als 0,5 mm. Auf diese Weise durchlaufen die flächigen Datenträger, und damit das Spinresonanz-Merkmal, einen Bereich besonders starken Anregungsfelds oberhalb des Streifenleitungs-Resonators, wodurch ein hoher Füllfaktor $\eta$ erzielt wird.

In einer Weiterbildung der Erfindung ist das Sensorelement der Prüfvorrichtung mit einem Schirmelement der oben genannten Art ausgestattet, das heißt, der Streifenleitungs-Resonator ist im Luftspalt parallel und beabstandet zu einem metallisierten Schirmelement angeordnet, um Abstrahlverluste des Resonators zu reduzieren. Die Transporteinrichtung der Prüfvorrichtung ist bei einer solchen Gestaltung ausgelegt und eingerichtet, die zu prüfenden flächigen Datenträger entlang eines Transportpfades in einem Schlitz zwischen dem Streifenleitungs-Resonator und dem Schirmelement zu führen. Diese Ausgestaltung ermöglicht eine besonders hohe Resonatorgüte Q.

In einer vorteilhaften Ausgestaltung stellt die Prüfvorrichtung einen Aufbau für eine gepulste Messung dar und weist dazu insbesondere eine Signalquelle für eine gepulste Ansteuerung des Streifenleitungs-Resonators auf. Eine gepulste Anwendung hat gegenüber einer CW-Anwendung den Vorteil, dass das Abklingverhalten und das Spektrum eines Spinresonanz-Merkmals schneller erfasst werden können.

In einer weiteren vorteilhaften Ausgestaltung stellt die Prüfvorrichtung einen Aufbau für ein Rapid-Scan Verfahren dar und weist dazu insbesondere eine leistungsstarke Signalquelle zur Ansteuerung des Resonators auf, und eine Vorrichtung zum schnellen Durchfahren der Polarisationsfeldstärke. Ein Rapid-Scan Verfahren hat gegenüber einer CW-Anwendung den Vorteil, dass das Spektrum eines Spinresonanz-Merkmals schneller erfasst werden kann.

Eine Messung im CW-Betrieb ermöglicht demgegenüber eine besonders einfache Ausgestaltung der Elektronik.

Die Prüfvorrichtung kann insbesondere Teil einer Banknotenbearbeitungsmaschine sein.

Die Erfindung enthält auch ein Verfahren zur Prüfung, insbesondere Echtheitsprüfung, eines flächigen Datenträgers mit einem Sensorelement, insbesondere der beschriebenen Art.

Bei dem Verfahren wird ein flächiger Datenträger mit einem Spinresonanz-Merkmal mittels eines Sensorelements geprüft. Es werden folgende Schritte durchgeführt:

- Bereitstellen des flächigen Datenträgers;
- Einführen des flächigen Datenträgers in einen Luftspalt eines Magnetkerns des Sensorelements;
- Anregen des Spinresonanz-Merkmals des flächigen Datenträgers durch einen in dem Luftspalt des Magnetkerns angeordneten Streifenleitungs-Resonator des Sensorelements;
- Erfassen eines Messsignals, welches charakteristisch für das Spinresonanz-Merkmal ist, durch den Streifenleitungs-Resonator; und
- Prüfen des flächigen Datenträgers anhand des erfassten Messsignals.

Bei dem Verfahren wird vorzugsweise der Streifenleitungs-Resonator in einer höheren räumlichen Mode des Anregungsfelds, insbesondere der zweiten oder dritten Mode des Anregungsfelds, betrieben. In einer ebenfalls vorteilhaften Verfahrensvariante wird die Prüfung mit gepulster Hochfrequenzanregung durchgeführt.

Die Merkmale der vorteilhaften Ausführungsformen des erfindungsgemäßen Sensorelements sind auch für das erfindungsgemäße Verfahren gültig. Umgekehrt sind die Merkmale der vorteilhaften Ausführungsformen des erfindungsgemäßen Verfahrens auch gültig für das erfindungsgemäße Sensorelement.

Insgesamt bietet der erfindungsgemäße Einsatz eines Streifenleitungs-Resonators im Luftspalt des Magnetkerns eine Reihe von Vorteilen:

- Zum einen kann der sensitive Bereich des Streifenleitungs-Resonators auf einfache Art und Weise mit einem flächigen Datenträgerprüfling, beispielsweise einer Banknote, beladen werden. Der sensitive Bereich ist für den Prüfling auch sehr gut zugänglich. Insbesondere können Banknoten auf einer schnell laufenden Bearbeitungsmaschine automatisiert durch den sensitiven Bereich des Resonators hindurch transportiert werden.
- Aufgrund seiner planaren Struktur ist der Füllfaktor $\eta$ eines Streifenleitungs-Resonators in besonderem Maße an flächige Prüflinge wie etwa Banknoten angepasst.
- Da die Anzahl der Partikel $N_S$ im Messbereich proportional zur Resonatorgröße ist, kann die Anzahl $N_S$ durch eine Vergrößerung des Resonators erhöht werden. Beträgt die Vergrößerung ein Vielfaches der charakteristischen Länge l, wird der Resonator also insbesondere in einer höheren Mode betrieben, so bleibt bei Vernachlässigung von Streueffekten die Resonanzfrequenz erhalten.
- Im Falle von Streifenleitungs-Resonatoren liegt die Güte Q typischerweise in der Größenordnung von 100, was sehr kurze Einschwingzeiten bis herab zu 100 ns und sogar unterhalb von 25 ns möglich macht. Damit kann der Streifenleitungs-Resonator bei einer Messung schnell-bewegter Prüflinge rasch auf die Resonanzfrequenz eingeregelt werden und er erlaubt zudem einen gepulsten Messbetrieb. Die Güte eines Streifenleitungs-Resonators kann, sofern dies anwendungstechnisch vorteilhaft ist, auch beispielsweise über ein zusätzliches Schirmelement weiter optimiert werden.

Weitere Ausführungsbeispiele sowie Vorteile der Erfindung werden nachfolgend anhand der Figuren erläutert, bei deren Darstellung auf eine maßstabs- und proportionsgetreue Wiedergabe verzichtet wurde, um die Anschaulichkeit zu erhöhen.

Es zeigen:

Fig. 1    schematisch eine Prüfvorrichtung für einen gepulsten Betrieb mit einem zugeführten Banknotenprüfling,

Fig. 2    schematisch einen mit einem Banknotenprüfling beladenen Streifenleitungs-Resonator im Querschnitt,

Fig. 3    in (a) bis (c) drei konkrete Ausgestaltungen erfindungsgemäßer Streifenleitungs-Resonatoren,

Fig. 4    schematisch einen Streifenleitungs-Resonator mit $\lambda/2$-Grundmode, in (a) ausgelegt für einen Betrieb in der Grundmode und in (b) ausgelegt für einen Betrieb in der dritten Mode,

Fig. 5    den Streifenleitungs-Resonator analog zu Fig. 2 zusammen mit einem Schirmelement,

Fig. 6    in (a) und (b) simulierte $B_1$-Feldverteilungen eines Streifenleitungs-Resonators mit einer rechteckigen leitenden Struktur,

Fig. 7    in (a) und (b) simulierte $B_1$-Feldverteilungen eines Streifenleitungs-Resonators mit einer leitenden Ringstruktur, und

Fig. 8    das Messsignal S eines Streifenleitungs-Resonators und eines dielektrischen Resonators in Abhängigkeit von der Stärke des Polarisationsfelds $B_0$.

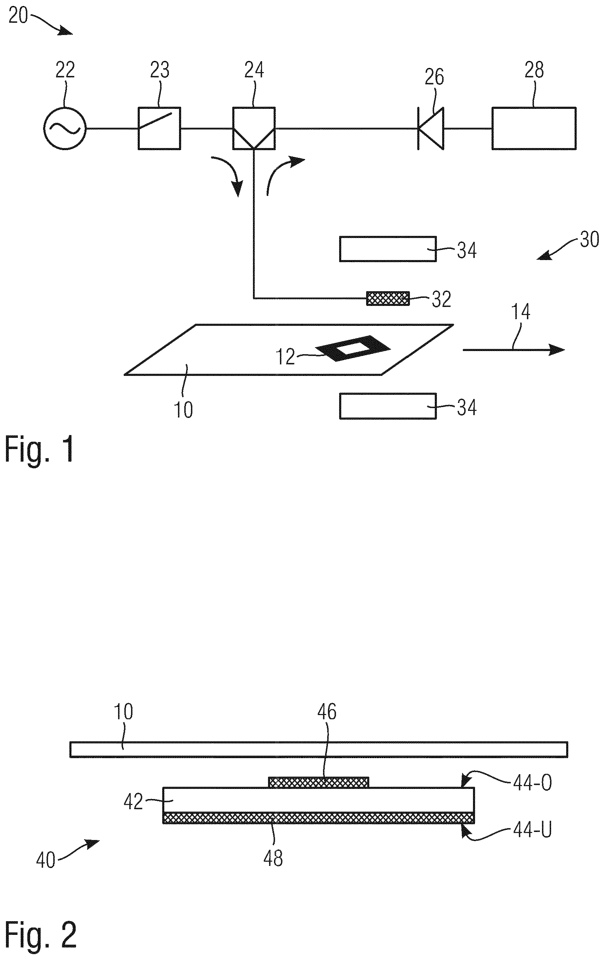

Die Erfindung wird nun am Beispiel der Echtheitsprüfung von Banknoten erläutert. Auch beispielsweise eine Qualitätskontrolle oder eine Prüfung auf Umlauffähigkeit sind mit dem Verfahren durchführbar. Figur 1 zeigt dazu schematisch eine Prüfvorrichtung 20 eines Banknotenbearbeitungssystems für die Messung von Spin-Resonanzen in einem Banknotenprüfling 10 in einem gepulsten Aufbau.

Der Banknotenprüfling 10 weist in einem Merkmalsbereich ein zu prüfendes Spinresonanz-Merkmal 12 auf, dessen charakteristische Eigenschaften zum Nachweis der Echtheit der Banknote dienen. Der Banknotenprüfling 10 wird für die Echtheitsprüfung entlang eines Transportpfads 14 durch ein nachfolgend genauer beschriebenes Sensorelement 30 der Prüfvorrichtung 20 geführt. Besondere Vorteile bietet die erfindungsgemäße Gestaltung bei der Prüfung schnell-laufender Banknoten, bei der die Banknotenprüflinge 10 mit hoher Geschwindigkeit durch das Sensorelement der Prüfvorrichtung 20 geführt werden.

Die Prüfvorrichtung 20 enthält eine Signalquelle 22 und in diesem Beispiel einen Schalter 23 zur Erzeugung resonanter Einzelpulse oder Pulssequenzen für die Anregung des Spinresonanz-Merkmals 12. Das gepulste elektrische Anregungssignal wird über einen Duplexer 24 einem Resonator 32 des Sensorelements 30 zugeführt, der sich im Feld eines Polarisationsmagneten 34 befindet, und erzeugt dort ein gepulstes magnetisches Wechselfeld. In den Pulspausen wird das Antwortsignal des Spinresonanz-Merkmals 12 vom Resonator 32 aufgenommen und über den Duplexer 24 zu einem Detektor 26 und einer Auswerteeinheit 28 geführt.

Als Besonderheit ist der Resonator 32 durch einen Streifenleitungs-Resonator gebildet, der im Luftspalt eines Polarisationsmagneten mit Magnetrückschluss angeordnet ist. Figur 2 zeigt zur näheren Erläuterung schematisch im Querschnitt eine Ausgestaltung eines solchen Streifenleitungs-Resonators 40, der mit einem Banknotenprüfling 10 beladen ist. Des Weiteren gezeigt sind Transportriemen 16, die einen Transport des Banknotenprüflings 10 in einer hier nicht gezeigten, senkrecht zur Bildebene verlaufenden Transportrichtung 14 bewirken. Ebenso möglich ist bei anderer Anordnung der Riemen ein Transport in links-rechts Richtung.

Der Streifenleitungs-Resonator 40 umfasst einen flächigen Träger 42, der im Ausführungsbeispiel durch eine Leiterplatte gebildet ist, in anderen Ausgestaltungen aber beispielsweise auch durch eine Keramik gebildet sein kann. Der Träger 42 weist eine dem Banknotenprüfling 10 zugewandte Oberseite 44-O und eine gegenüberliegende Unterseite 44-U auf, wobei auf der Oberseite 44-O des Trägers eine leitende Struktur 46 mit einer charakteristischen Länge l, und als Masserückführung auf der Unterseite 44-O eine Massefläche 48 angeordnet ist. Der Signalleiter und die Ankoppelung der leitenden Struktur 46 sind in Fig. 2 der Übersichtlichkeit halber nicht dargestellt. Es bildet sich ein in Fig. 2 gezeigtes $B_1$-Feld mit Feldlinien entlang der Ebene des Banknotenprüflings 10, hier in links-rechts Richtung, aus. Ebenso möglich ist bei anderer Anordnung des Resonators ein Verlauf der Feldlinien senkrecht zur Bildebene. Die Feldlinien des B1-Feldes und die Transportrichtung stehen in diesem Beispiel senkrecht zueinander, eine parallele Anordnung ist aber ebenso möglich.

Passt bei der Prüfung die Leiterbahn-Wellenlänge $\lambda$ des eingekoppelten Hochfrequenzsignals zu der Abmessung l der leitenden Struktur 46, so kann sich im Resonator eine stehende Welle ausbilden, und der Streifenleitungs-Resonator 40 ist zu der zur Wellenlänge $\lambda$ gehörenden Anregungsfrequenz in Resonanz.

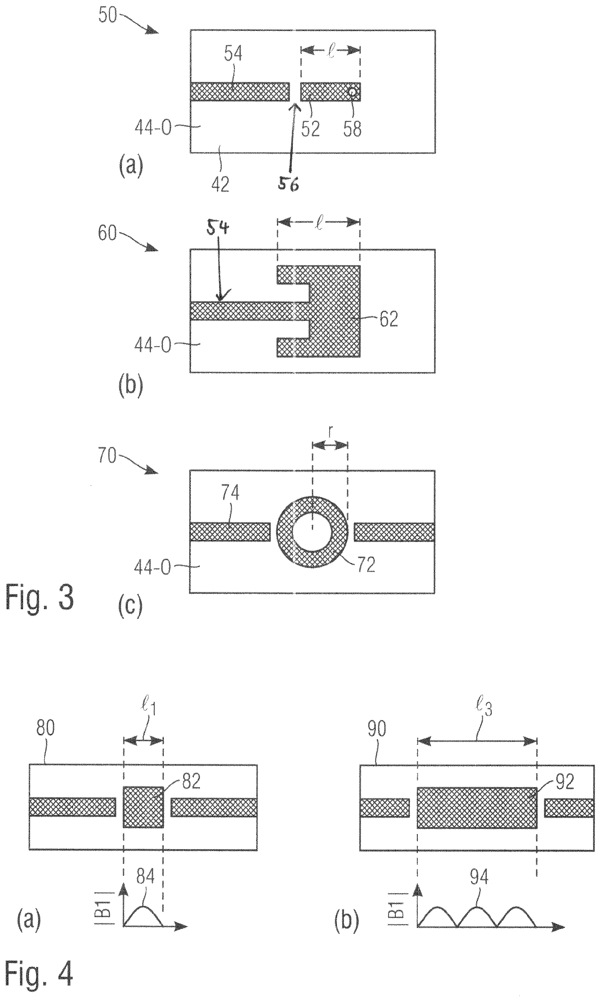

Figur 3 zeigt in (a) bis (c) zur Illustration drei konkrete Ausgestaltungen geeigneter Streifenleitungs-Resonatoren in Aufsicht. Die Masserückführung ist jeweils auf der nicht sichtbaren Unterseite des Trägers angeordnet.

Der Streifenleitungs-Resonator 50 der Fig. 3(a) bildet eine $\lambda/4$-Grundmode aus. Die leitende Struktur 52 ist auf der Oberseite 44-O einer Leiterplatte 42 angeordnet und durch eine Rechteckstruktur 52 mit einer Längsabmessung l gebildet. Die Rechteckstruktur 52 ist auf einer Seite kapazitiv an den Signalleiter 54 gekoppelt (Bezugszeichen 56), an der anderen Seite ist die Rechteckstruktur 52 über eine Durchkontaktierung 58 mit der auf der Unterseite befindlichen Masserückführung verbunden. Die Breite der Rechteckstruktur 52 ist durch die Leiterbahnbreite gegeben und beträgt beispielsweise 1,8 mm. Auch andere Breiten beispielsweise im Bereich von 0,2 mm bis 10 mm sind möglich. Der Resonator 50 der Fig. 3(a) wird in Reflexion betrieben, und die Resonanzbedingung für die Linearstruktur 52 lautet

$$l = n^* \lambda/4,$$

wobei n einen Modenfaktor darstellt, der in dieser Ausgestaltung eine ungerade ganze Zahl größer oder gleich 1 sein muss. Abhängig von der effektiven Permittivität des Aufbaus kann die Länge l beispielsweise 14,9 mm für eine Resonanzfrequenz von 3 GHz betragen, wobei in diesem Beispiel eine effektive Permittivität von 2,78 gewählt wurde.

Der Streifenleitungs-Resonator 60 der Fig. 3(b) bildet eine $\lambda/2$-Grundmode aus und weist eine auf der Oberseite 44-O einer Leiterplatte angeordnete leitende Struktur 62 einer charakteristischen Länge l auf, die über einen an sich bekannten sogenannten Inset-Feed an den Signalleiter 54 gekoppelt ist. Auch der Resonator 60 der Fig. 3(b) wird in Reflexion betrieben, wobei die Resonanzbedingung für die leitende Struktur 62

$$l = n^* \lambda/2,$$

lautet, mit einem Modenfaktor n, der in diesem Fall eine ganze Zahl größer oder gleich 1 darstellt. Die Länge l kann beispielsweise 29,9 mm für eine Resonanzfrequenz von 3 GHz und eine effektive Permittivität von 2,78 betragen. Bei einer effektiven Permittivität von 2,02 und einer Resonanzfrequenz von 20 GHz ergibt sich eine charakteristische Länge l von 5,3 mm.

Der in Fig. 3(c) gezeigte Streifenleitungs-Resonator 70 bildet eine $\lambda$-Grundmode aus und weist eine auf der Oberseite 44-O einer Leiterplatte angeordnete leitende Ringstruktur 72 auf, die kapazitiv an den Signalleiter 74 gekoppelt ist. Die charakteristische Länge l der Ringstruktur 72 ist durch ihren Umfang l = 2πr, mit dem Ringradius r bis zur Mitte der Leiterbahn, gegeben. Der Betrieb des Resonators 70 der Fig. 3(c) erfolgt in Transmission, die Resonanzbedingung der leitenden Struktur 72 lautet

$$l = 2\pi r = n^* \lambda,$$

mit einem Modenfaktor n, der eine ganze Zahl größer oder gleich 1 darstellt. Beispielsweise ist die Leiterbahn bei einer Resonanzfrequenz von 3 GHz 1,8 mm breit und hat einen Umfang von 59,7 mm.

Die Streifenleitungs-Resonatoren sind insbesondere so ausgelegt, dass ihre Resonanzfrequenz f der erwarteten Larmorfrequenz $f_L$ des Spinresonanz-Merkmals bei den vorgegebenen Messbedingungen entspricht. Beispielsweise ist beim Resonator in Fig. 3(b) die charakteristische Länge l für eine Resonanzfrequenz f gegeben durch

$$l = n^* c/(2^* f^* \sqrt{\varepsilon_{eff}}) - \Delta l,$$

wobei $\varepsilon_{eff}$ die effektive Permittivität des Aufbaus, c die Lichtgeschwindigkeit, und $\Delta l$ eine an sich bekannte Längenkorrektur zur Berücksichtigung elektrischer Streufelder am Rand des Resonators darstellt. Wählt man in der angegebenen Beziehung für f die erwartete Larmorfrequenz $f_L$ des Spinresonanz-Merkmals, so erhält man die für die Prüfung geeignete charakteristische Länge l der leitenden Struktur 62.

Es versteht sich, dass die geometrischen Formen der leitenden Strukturen 52, 62, 72 der Fig. 3 nur beispielhaft gezeigt sind. Neben Rechteck- und Ringstrukturen kommen als leitende Strukturen beispielsweise auch scheibenförmige Strukturen mit runder oder elliptischer Außenkontur, Ringe mit elliptischen Außenkanten, Ringsektoren und Elemente mit einer zugrundeliegenden Dreieck- oder Vieleckform in Betracht. Auch Kombinationen solcher Grundelemente sind möglich. Für komplexere Gestaltungen der leitenden Strukturen existieren in der Regel keine geschlossenen analytischen Formeln für die Abhängigkeit der charakteristischen Länge von der Resonanzfrequenz, die geeignete charakteristische Länge für eine gewünschte Resonanzfrequenz kann jedoch ohne Weiteres mit Hilfe eines Simulationstools bestimmt werden.

In Fig. 3 sind als Kopplungsmechanismen eine kapazitive Kopplung und eine Kopplung über einen Inset-Feed illustriert. Daneben besteht auch die Möglichkeit einer Ankoppelung der leitenden Struktur über eine Apertur-Kopplung oder eine koaxiale Kopplung. Weiter besteht neben der in Fig. 3 gezeigten Variante, die leitenden Strukturen in Serie zum Signalleiter anzukoppeln, insbesondere bei einem in Transmission betriebenen Streifenleitungs-Resonator auch die Möglichkeit, die Ankoppelung parallel zum Signalleiter vorzunehmen. Das heißt, der Signalleiter wird durch den Resonator nicht unterbrochen. Stattdessen befindet sich der Resonator neben dem Signalleiter, eine Kopplung geschieht dann durch ein Übersprechen des Hochfrequenzsignals aus dem Signalleiter in den Resonator.

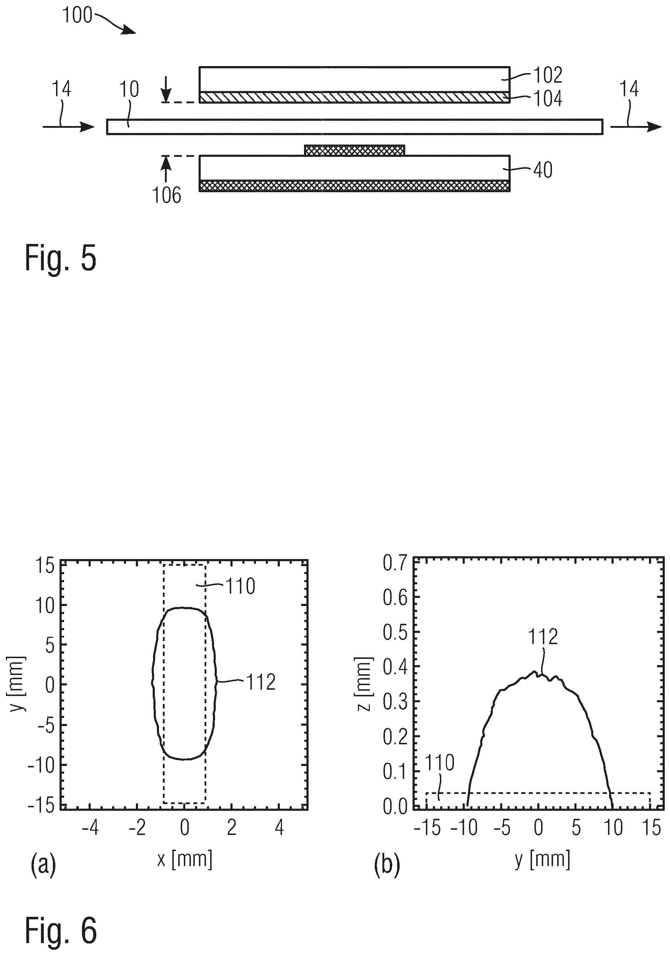

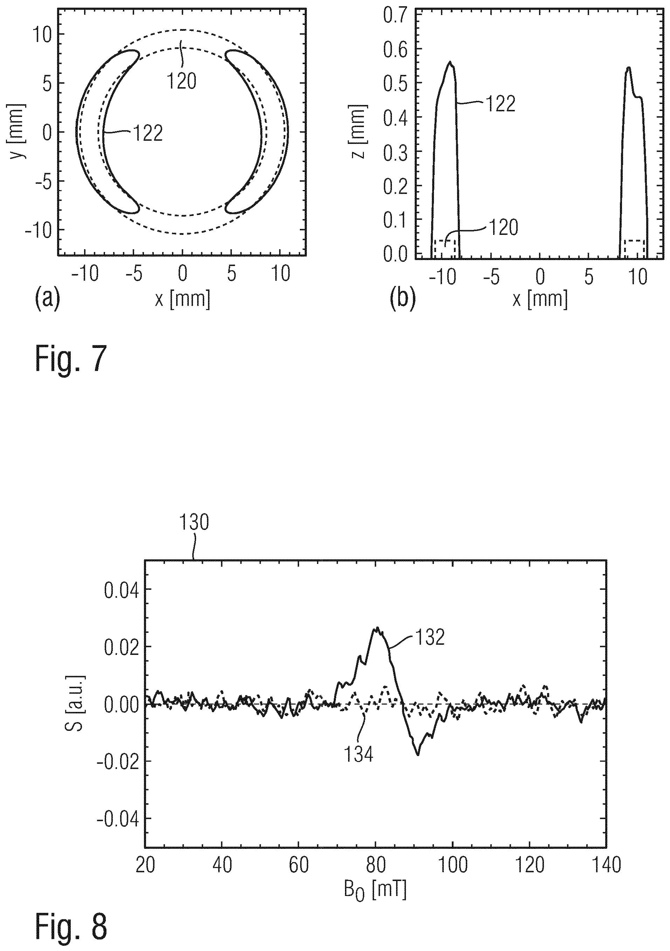

Der für die Anwendung bei der Prüfung von Banknoten vorteilhafte hohe Füllfaktor des Streifenleitungs-Resonators ergibt sich insbesondere aus der an die Geometrie einer Banknote oder eines anderen flächigen Datenträgers besonders gut angepassten räumlichen Verteilung des erzeugten $B_1$-Felds, das an der Oberseite des Resonators am stärksten ist und mit zunehmendem Abstand vom Resonator stark abfällt (siehe Figuren 6(b), 7(b) weiter unten). Wie in Fig. 2 illustriert, wird eine solche Feldverteilung von einem Banknotenprüfling 10 in seiner Messposition optimal ausgefüllt, so dass ein hoher Füllfaktor $\eta$ und damit eine hohe Signalstärke bei der Messung resultiert.

Aus der Darstellung der Fig. 2 ist auch ersichtlich, dass der in einem Prüfling 10 von der leitenden Struktur 46 erfasste Bereich und damit auch die Anzahl $N_S$ der erfassten Partikel proportional zur charakteristischen Fläche der leitenden Struktur ist. Da die benötigte Resonanzfrequenz des Streifenleitungs-Resonators durch die Larmorfrequenz $f_L$ der zu prüfenden Substanz im Wesentlichen vorgegeben ist, kann die charakteristische Länge I der leitenden Struktur nicht frei gewählt werden. Um eine besonders große Anzahl $N_S$ an Partikeln zu erfassen, kann ein Streifenleitungs-Resonator mit einer höheren Mode des Anregungsfelds aufgebaut werden.

Figur 4 illustriert hierzu in (a) schematisch einen $\lambda/2$-Streifenleitungs-Resonator 80 mit einer leitenden Struktur 82, die auf einen Betrieb in der Grundmode n = 1 für eine vorgegebene Larmorfrequenz $f_L$ ausgelegt ist und die entsprechend eine bestimmte charakteristische Länge $I_1$ aufweist. Der in Fig. 4(b) gezeigte $\lambda/2$-Streifenleitungs-Resonator 90 ist auf dieselbe Larmorfrequenz $f_L$, allerdings bei Betrieb in der dritten Mode n= 3 ausgelegt. Die charakteristische Länge $I_3$ der leitenden Struktur 92 ist daher bei derselben Resonanzfrequenz $f_L$ dreimal so groß wie die charakteristische Länge $I_1$ der leitenden Struktur 82 der Fig. 4(a).

Der zugehörige Verlauf des jeweils erzeugten $B_1$-Felds (Kurve 84 bzw. 94) ist schematisch jeweils unterhalb der Streifenleitungs-Resonatoren 80, 90 gezeigt. Wie unmittelbar ersichtlich, kann mit dem Streifenleitungs-Resonator 90 der Fig. 4(b) verglichen mit dem Resonator 80 der Fig. 4(a) ein etwa dreimal so großer Flächenbereich eines Prüflings 10 abgedeckt und damit idealerweise eine dreifache Anzahl $N_S$ von Partikeln erfasst werden. Eine weitere Erhöhung der Partikelzahl $N_S$ kann in manchen Fällen durch eine Verbreiterung der leitenden Fläche 82, 92 bei gleichbleibender Länge erreicht werden.

Die Güte Q eines erfindungsgemäßen Streifenleitungs-Resonators beträgt typischerweise etwa 100 und liegt damit deutlich unterhalb der typischen Güte eines Hohlraumresonators. Nach gegenwärtigem Verständnis beruht die niedrigere Güte vor allem darauf, dass die elektromagnetischen Schwingungen der Streifenleitungs-Resonatoren vorrangig in der auf dem Träger offen aufgebrachten leitenden Struktur ausgeprägt sind. Hierbei treten metallische Verluste im Material der leitenden Struktur (beispielsweise Kupfer), dielektrische Verluste im Trägermaterial (beispielsweise FR4-Materialien) und auch Abstrahlverluste durch Antenneneffekte auf, die jeweils zu einer Dämpfung und damit zu einer verringerten Resonatorgüte führen.

Es hat sich allerdings überraschend gezeigt, dass eine Güte im Bereich von etwa Q = 50 bis etwa Q = 400 für Spinresonanz-Messungen an schnell-laufenden Datenträgern keinen Nachteil darstellt, sondern im Gegenteil sogar mit mehreren Vorteilen verbunden ist.

Einerseits ist, wie oben bereits genauer erläutert, eine niedrigere Güte für Messungen an schnell bewegten Proben und für gepulste Verfahren grundsätzlich vorteilhaft, da eine hohe Resonatorgüte stets mit einer langen Einschwingzeit des Resonators verbunden ist. Die Güte darf allerdings auch nicht zu gering sein, da die Signalintensität proportional mit der Güte steigt. Die optimale Güte eines Resonators für die Messung an schnell-bewegten Proben ergibt sich daher aus einer sorgfältigen Abwägung der beiden Faktoren Signalintensität und Zeitkonstante, und es hat sich gezeigt, dass eine Güte in der Größenordnung 100 für den erfindungsgemäßen Zweck einen guten Kompromiss zwischen den beiden gegenläufigen Anforderungen darstellt.

Zusätzlich kann die Güte eines Streifenleitungs-Resonators im Rahmen der geforderten Messdynamik durch mehrere Maßnahmen optimiert werden. Metallische Verluste können durch die Materialwahl der leitenden Struktur reduziert werden, beispielsweise indem der Leiter anstelle von Kupfer durch Silber gebildet wird. Bei den hohen Betriebsfrequenzen ist aufgrund des Skin-Effekts auch oft schon eine Silberbeschichtung des Leiters ausreichend. Weiterhin kann die Güte durch die Verwendung von Leiterstrukturen mit geringer Oberflächenrauigkeit erhöht werden. Zur Verringerung dielektrischer Verluste können geeignete Materialien für den Träger des Streifenleitungs-Resonators verwendet werden, beispielsweise auf Basis von Keramik, Teflon oder Kohlenwasserstoffen.

Abstrahlverluste können schließlich beispielsweise durch einen Schirm reduziert werden, wie in Fig. 5 illustriert. Die Figur zeigt einen Streifenleitungs-Resonator 40 analog zu Fig. 2, kombiniert mit einem Schirmelement 100, welches durch eine Leiterplatte 102 mit einer Metallisierung 104 gebildet ist. Der Streifenleitungs-Resonator 40 und das Schirmelement 100 definieren zwischen sich einen Schlitz 106, in dem der Transportpfad 14 des Banknotenprüflings 10 verläuft. Die gute Banknoten-Zugänglichkeit des sensitiven Resonators-Bereichs wird durch das Schirmelement 100 daher nicht beeinträchtigt.

Die Figuren 6 und 7 illustrieren die vorteilhafte $B_1$-Feldverteilung zweier Streifenleitungs-Resonatoren nach Ausführungsbeispielen der Erfindung.

Ein erster Streifenleitungs-Resonator weist eine rechteckige leitende Struktur 110 mit einer Breite von 1,8 mm und einer Länge von 29,9 mm auf. Der Resonator ist auf einer 0,81 mm dicken Leiterplatte mit einer relativen Permittivität von 3,55 implementiert, woraus sich für den Aufbau eine effektive Permittivität von 2,78 ergibt. Der erste Streifenleitungs-Resonator hat eine Resonanzfrequenz von rund 3 GHz und wird in der Grundmode n = 1 betrieben. Bei der Ausrichtung wurde angenommen, dass der Streifenleitungs-Resonator in der x-y-Ebene zentriert ist. Figur 6 zeigt die Geometrie der leitenden Struktur 110 und die mit einem Simulationstool berechnete Feldverteilung der Grundmode anhand der 50%-Konturlinie 112, die den Bereich des Magnetfelds eingrenzt, in dem die $B_1$-Stärke mehr als 50% des globalen Maximalwerts erreicht. Figur 6(a) zeigt dabei die Geometrie und Feldverteilung in der x-y-Ebene bei z = 0,035 mm, also an der Oberseite des Streifenleitungs-Resonators, und Fig. 6(b) die Geometrie und Feldverteilung in der y-z-Ebene bei x = 0, also entlang der Längsachse des Streifenleitungs-Resonators.

Ein zweiter Streifenleitungs-Resonator enthält als leitende Struktur 120 eine Ringstruktur mit einer Leitbahnbreite von 1,8 mm und einem Umfang von 59,7 mm in der Mitte der Leiterbahn. Der Resonator ist auf einer Leiterplatte mit denselben Spezifikationen wie der Resonator der Fig. 6 implementiert. Auch dieser Streifenleitungs-Resonator hat eine Resonanzfrequenz von rund 3 GHz und wird in der Grundmode n=1 betrieben. Figur 7 zeigt die Geometrie der leitenden Struktur 120 und die berechnete Feldverteilung der Grundmode anhand der 50%-Konturlinie 122. Dabei zeigt Fig. 7(a) die Geometrie und Feldverteilung in der x-y-Ebene bei z = 0,035 mm, also an der Oberseite des Streifenleitungs-Resonators, und Fig. 7(b) die Geometrie und Feldverteilung in der x-z-Ebene bei y = 0, also entlang der Achse der Signalleiter.

Wie aus den Figuren 6(b) und 7(b) unmittelbar ersichtlich, konzentriert sich das $B_1$-Feld der leitenden Strukturen 110, 120 jeweils an der Oberseite der Resonatoren und fällt dann über wenige Zehntel Millimeter mit größer werdendem Abstand in z-Richtung schnell ab. Das $B_1$-Feld einer solchen Verteilung ist für einen Banknotenprüfling 10 sehr gut zugänglich.

Zur Quantifizierung dieser Zugänglichkeit wurde basierend auf den berechneten Feldverteilungen der Füllfaktor $\eta$ der Resonatoren berechnet. Neben den beiden im Zusammenhang mit Fig. 6 und 7 bereits beschriebenen Resonatoren wurde ein dritter Streifenleitungs-Resonator in die Berechnung einbezogen, der eine rechteckige leitende Struktur mit einer Breite von 1,8 mm und einer Länge von 59,8 mm aufweist und auf einer Leiterplatte mit denselben Spezifikationen wie der Resonator der Fig. 6 implementiert wurde. Der dritte Resonator hat eine Resonanzfrequenz von ebenfalls rund 3 GHz und wird in der zweiten Mode n=2 betrieben.

Als Vergleichsbeispiel dient ein herkömmlicher dielektrischer Resonator mit zylindrischer Geometrie mit einem Außendurchmesser von 17,9 mm, einem Innendurchmesser von 5,5 mm, einer Höhe von 10,6 mm und einer relativen Permeabilität von 37.

Für den Vergleich wurde jeweils angenommen, dass die Resonatoren mit einem 100 $\mu$m dicken Banknotenprüfling beladen sind, der im Fall der Streifenleitungs-Resonatoren direkt auf der Oberseite der Resonatoren, sowie im Fall des dielektrischen Resonators auf der kreisförmigen Grundfläche des Zylinders angeordnet ist. Als Maß für die Anzahl $N_S$ der jeweils gemessenen Partikel dient der Flächeninhalt $A_{50}$, der die Fläche innerhalb einer 50%-Kontur der $B_1$-Verteilung angibt. Dieser Flächeninhalt wurde dabei zweimal bestimmt, nämlich einmal (nachfolgend $A_{50,\ loc}$) für eine $B_1$-Verteilung, die auf ihr lokales Maximum in der Ebene des Banknotenprüflings normiert ist, und einmal (nachfolgend $A_{50,\ glob}$) für eine $B_1$-Verteilung, die auf ihr globales Maximum innerhalb des Gesamtvolumens normiert ist.

Tabelle 1 fasst die berechneten Füllfaktoren und Flächeninhalte für die vier Resonatoren zusammen:

|  | $\eta$ (%) | $A_{50,\ loc}$ (mm$^2$) | $A_{50,\ glob}$ (mm$^2$) |
|---|---|---|---|
| Rechteck-Resonator (n=1) | 5,5 | 50 | 43 |
| Rechteck-Resonator (n=2) | 5,7 | 95 | 85 |
| Ring-Resonator (n=1) | 5,4 | 101 | 94 |
| dielektrischer Resonator (Vergleichsbeispiel) | 0,2 | 168 | 0 |

Wie aus der Tabelle ersichtlich, weisen die Streifenleitungs-Resonatoren bei einem Einsatz bei der Messung von Spinresonanz-Merkmalen flächiger Datenträger einen mindestens 27-fach höheren Füllfaktor $\eta$ auf als der als Vergleichsbeispiel herangezogene dielektrische Resonator.

Darüber hinaus belegen die berechneten $A_{50}$- Flächeninhalte, dass sich die Anzahl $N_S$ der untersuchten Partikel durch eine Erhöhung der Resonatormode steigern lässt. Der Rechteck-Resonator mit n=2 weist fast die doppelte $A_{50}$-Fläche auf wie der Rechteck-Resonator in der Grundmode mit n=1.

Ein Vergleich der lokalen und globalen $A_{50}$-Flächen für jeden der Resonatoren verdeutlicht, dass sich der Banknotenprüfling bei den Streifenleitungs-Resonatoren jeweils in einem Bereich mit fast maximalem $B_1$-Feld befindet ($A_{50,\ glob} \approx A_{50,\ loc}$), während sich der Banknotenprüfling bei dem dielektrischen Resonator nur in einem schwachen Randbereich des erzeugten Felds befindet ($A_{50,\ glob} \approx 0$).

Für eine experimentelle Verifikation wurde schließlich eine Papier-Probe mit einem Spin-Marker beladen und anschließend über einen $B_0$-Sweep das Spinresonanz-Spektrum des Markers in der Papier-Probe aufgezeichnet. Das $B_0$-Feld zeigte dabei parallel zur z-Achse. Die Messung wurde mit zwei verschiedenen Resonatoren durchgeführt.

Bei einer ersten Messung wurde ein erfindungsgemäßer Streifenleitungs-Resonator eingesetzt, der eine leitende Struktur rechteckiger Geometrie mit einer Länge von 40 mm und eine Breite von 2,3 mm aufwies. Die leitende Struktur war auf einer Leiterplatte mit einer Dicke von 0,5 mm und einer relativen Permittivität von 2,33, und damit in einem Aufbau mit einer effektiven Permittivität von 2,02 angeordnet. Der Streifenleitungs-Resonator hatte eine Resonanzfrequenz von 2,6 GHz, eine Güte von Q = 104 und war so ausgerichtet, dass er sich in der x-y-Ebene senkrecht zur $B_0$-Richtung befand.

Bei einer zweiten Messung wurde als Vergleichsbeispiel ein herkömmlicher dielektrischer Resonator eingesetzt, dessen Parameter den oben bei der Simulation beschriebenen Parametern entsprachen. Der bekannte dielektrische Resonator hatte eine Resonanzfrequenz von 3,0 GHz und eine Güte von 800. Auf Grund der Geometrie des bekannten dielektrischen Resonators konnten nur die Streukomponenten des $B_1$-Feldes zur Messung der Papier-Probe verwendet werden. Deswegen wurde der bekannte dielektrische Resonator so ausgerichtet, dass seine Zylinderachse parallel zur z-Achse zeigte. Aufgrund der etwas höheren Resonanzfrequenz war zu erwarten, dass eine Spinresonanz bei der Messung mit dem dielektrischen Resonator bei einem etwa 15% höheren $B_0$-Feld auftritt als bei dem Streifenleitungs-Resonator gemäß dem Ausführungsbeispiel der Erfindung.

Im Experiment wurde die Papierprobe direkt auf die Oberseite der jeweiligen Resonatoren in der x-y-Ebene gelegt. Die Ergebnisse der beiden Messungen sind in dem Diagramm 130 der Fig. 8 zusammengefasst, das das Messsignal S des Streifenleitungs-Resonators (Kurve 132) und des dielektrischen Resonators (Kurve 134) in Abhängigkeit von der Stärke des Polarisationsfelds $B_0$ zeigt.

Aus dem Diagramm der Fig. 8 ist deutlich ersichtlich, dass nur der erfindungsgemäße Streifenleitungs-Resonator, nicht aber der dielektrische Resonator ein Spinresonanz-Signal erfasst. Der vorteilhafte Einfluss des höheren Füllfaktors $\eta$ dominiert also klar die geringere Güte Q des Streifenleitungs-Resonators und führt im Ergebnis zu einer verbesserten Detektion.

Bezugszeichenliste

| | |
|---|---|
| 10 | Banknotenprüfling |
| 12 | Spinresonanz-Merkmal |
| 14 | Transportpfad |
| 20 | Prüfvorrichtung |
| 22 | Signalquelle |
| 23 | Schalter |
| 24 | Duplexer |
| 26 | Detektor |
| 28 | Auswerteeinheit |
| 30 | Sensorelement |
| 32 | Resonator |
| 34 | Polarisationsmagnet |
| 40 | Streifenleitungs-Resonator |
| 42 | Träger |
| 44-O, 44-U | Oberseite, Unterseite Träger |
| 46 | leitende Struktur |
| 48 | Massefläche |
| 50 | Streifenleitungs-Resonator |
| 52 | leitende Struktur, Rechteckstruktur |
| 54 | Signalleiter |
| 56 | Koppelung |
| 58 | Durchkontaktierung |
| 60 | Streifenleitungs-Resonator |
| 62 | leitende Struktur |
| 70 | Streifenleitungs-Resonator |
| 72 | leitende Struktur |
| 74 | Signalleiter |
| 80 | $\lambda/2$-Streifenleitungs-Resonator |

| | |
|---|---|
| 82 | leitende Struktur |
| 84 | Verlauf $B_1$-Feld |
| 90 | $\lambda/2$-Streifenleitungs-Resonator |
| 92 | leitende Struktur |
| 94 | Verlauf $B_1$-Feld |
| 100 | Schirmelement |
| 102 | Leiterplatte |
| 104 | Metallisierung |
| 106 | Schlitz |
| 110 | rechteckige leitende Struktur |
| 112 | Feldverteilung |
| 120 | leitende Struktur, Ringstruktur |
| 122 | Feldverteilung |
| 130 | Diagramm |
| 132 | Messsignal Streifenleitungs-Resonator |
| 134 | Messsignal dielektrischer Resonator |

**Patentansprüche**

1. Sensorelement (30) für die Prüfung eines flächigen Datenträgers (10), insbesondere einer Banknote, mit einem Spinresonanz-Merkmal (12), mit

- einem Magnetkern (34) mit einem Luftspalt, in den der flächige Datenträger (10) zur Prüfung einbringbar ist,
- einem Element zu Erzeugung eines statischen magnetischen Flusses in dem Luftspalt, und
- einem Resonator (32) zur Anregung des Spinresonanz-Merkmals des zu prüfenden Datenträgers,

**dadurch gekennzeichnet, dass**

- der Resonator durch einen in dem Luftspalt des Magnetkerns angeordneten Streifenleitungs-Resonator (40) gebildet ist, der einen flächigen Träger (42) mit einer Oberseite (44-O) aufweist, wobei auf der Oberseite (44-O) eine leitende Struktur (46) mit einer charakteristischen Länge l angeordnet ist.

2. Sensorelement nach Anspruch 1, **dadurch gekennzeichnet, dass** der Träger (42) eine der Oberseite (44-O) gegenüberliegende Unterseite (44-U) und eine auf der Unterseite (44-U) angeordnete Massefläche (48) aufweist.

3. Sensorelement nach Anspruch 1 oder 2, **dadurch gekennzeichnet, dass** der Streifenleitungs-Resonator (40) eine $\lambda/4$-Grundmode, eine $\lambda/2$-Grundmode oder eine $\lambda$-Grundmode bildet.

4. Sensorelement nach wenigstens einem der Ansprüche 1 bis 3, **dadurch gekennzeichnet, dass** der Streifenleitungs-Resonator (40) als leitende Struktur eine Rechteckstruktur, eine Ringstruktur mit kreisförmiger oder elliptischer Außenkontur, eine scheibenförmige Struktur, eine Ringsektoren-Struktur mit runden oder elliptischen Außenkanten, oder eine Struktur mit einer Dreieck- oder Vieleckform umfasst.

5. Sensorelement nach wenigstens einem der Ansprüche 1 bis 4, **dadurch gekennzeichnet, dass** der Streifenleitungs-Resonator (40) mit seiner charakteristischen Länge l auf die Prüfung des Spinresonanz-Merkmals des Datenträgers in einer höheren räumlichen Mode des Anregungsfelds, insbesondere der zweiten oder dritten Mode des Anregungsfelds, ausgelegt und eingerichtet ist.

6. Sensorelement nach wenigstens einem der Ansprüche 1 bis 5, **dadurch gekennzeichnet, dass** der Streifenleitungs-Resonator (40) eine Güte Q zwischen 50 und 400, insbesondere zwischen 80 und 300, aufweist.

7. Sensorelement nach wenigstens einem der Ansprüche 1 bis 6, **dadurch gekennzeichnet, dass** der Streifenleitungs-Resonator (40) auf die Anregung von Spinresonanz-Signalen mit einer Frequenz zwischen 1 GHz und 100 GHz, bevorzugt zwischen 5 GHz und 85 GHz, und besonders bevorzugt zwischen 15 GHz und 50 GHz, ausgelegt ist.

8. Sensorelement nach wenigstens einem der Ansprüche 1 bis 7, **dadurch gekennzeichnet, dass** der Streifenleitungs-Resonator (40) im Luftspalt parallel und beabstandet zu einem metallisierten Schirmelement (100) angeordnet ist, um Abstrahlverluste des Resonators zu reduzieren.

9. Sensorelement nach wenigstens einem der Ansprüche 1 bis 8, **dadurch gekennzeichnet, dass** das Sensorelement (30) für die Prüfung eines Elektronspin-Resonanz-Merkmals oder eines ferromagnetischen bzw. ferrimagnetischen Resonanz-Merkmals ausgelegt und eingerichtet ist.

10. Prüfvorrichtung (20) für die Prüfung flächiger Datenträger, insbesondere Banknoten, mit einem Sensorelement (30) nach einem der Ansprüche 1 bis 9 und mit einer Transporteinrichtung, die die zu prüfenden flächigen Datenträger entlang eines Transportpfades (14) in den Luftspalt des Magnetkerns einbringt bzw. durch den Luftspalt des Magnetkerns hindurchführt.

11. Prüfvorrichtung (20) nach Anspruch 10, **dadurch gekennzeichnet, dass** die Transporteinrichtung auf einen schnell-laufenden Transport der zu prüfenden flächigen Datenträger entlang des Transportpfades (14) ausgelegt und eingerichtet ist.

12. Prüfvorrichtung (20) nach Anspruch 10 oder 11, **dadurch gekennzeichnet, dass** die Transporteinrichtung ausgelegt und eingerichtet ist, die zu prüfenden flächigen Datenträger entlang eines Transportpfades (14) in geringem Abstand über die Oberseite des Streifenleitungs-Resonators (40) zu führen.

13. Prüfvorrichtung (20) nach wenigstens einem der Ansprüche 10 bis 12, **dadurch gekennzeichnet, dass** das Sensorelement (30) nach Anspruch 8 mit einem Schirmelement (100) ausgestattet ist, und die Transporteinrichtung ausgelegt und eingerichtet ist, die zu prüfenden flächigen Datenträger entlang eines Transportpfades (14) in einem Schlitz zwischen dem Streifenleitungs-Resonator (40) und dem Schirmelement (100) zu führen.

14. Prüfvorrichtung (20) nach wenigstens einem der Ansprüche 10 bis 13, **dadurch gekennzeichnet, dass** die Prüfvorrichtung eine Signalquelle (22, 23) für eine gepulste Ansteuerung des Streifenleitungs-Resonators (40) und/oder für einen Betrieb des Streifenleitungs-Resonators (40) im Rapid-Scan Verfahren und/oder im CW-Verfahren aufweist.

15. Verfahren zur Prüfung eines flächigen Datenträgers (10) mit einem Spinresonanz-Merkmal (12) mittels eines Sensorelements (30), bei welchem folgende Schritte durchgeführt werden:

    - Bereitstellen des flächigen Datenträgers (10);
    - Einführen des flächigen Datenträgers (10) in einen Luftspalt eines Magnetkerns des Sensorelements (30);
    - Anregen des Spinresonanz-Merkmals (12) des flächigen Datenträgers (10) durch einen in dem Luftspalt des Magnetkerns angeordneten Streifenleitungs-Resonator (40) des Sensorelements (30);
    - Erfassen eines Messsignals (S), welches charakteristisch für das Spinresonanz-Merkmal (12) ist, durch den Streifenleitungs-Resonator (40); und
    - Prüfen des flächigen Datenträgers (10) anhand des erfassten Messsignals (S).

**Claims**

1. Sensor element (30) for the testing of a flat data carrier (10), in particular a banknote, with a spin resonance feature (12), with

    - a magnetic core (34) with an air gap, into which the flat data carrier (10) can be introduced for testing,
    - an element for generating a static magnetic flux in the air gap, and
    - a resonator (32) for excitation of the spin resonance feature of the data carrier to be tested,

**characterized in that**

    - the resonator is formed by a stripline resonator (40) arranged in the air gap of the magnetic core, which has a flat carrier (42) with a top side (44-O), wherein on the top side (44-O) a conductive structure (46) with a characteristic length l is arranged.

2. Sensor element according to claim 1, **characterized in that** the carrier (42) has a bottom side (44-U) opposite the top side (44-O) and a ground surface (48) arranged on the bottom side (44-U).

3. Sensor element according to claim 1 or 2, **characterized in that** the stripline resonator (40) forms a $\lambda/4$ fundamental

mode, a $\lambda/2$ fundamental mode or a $\lambda$ fundamental mode.

4. Sensor element according to at least one of claims 1 to 3, **characterized in that** the stripline resonator (40) comprises, as a conductive structure, a rectangular structure, a ring structure with circular or elliptical outer contour, a disk-shaped structure, a ring-sector structure with rounded or elliptical outer edges, or a structure with a triangular or polygonal shape.

5. Sensor element according to at least one of claims 1 to 4, **characterized in that** the stripline resonator (40) is designed and configured, with its characteristic length l, for the testing of the spin resonance feature of the data carrier in a higher spatial mode of the excitation field, in particular the second or third mode of the excitation field.

6. Sensor element according to at least one of claims 1 to 5, **characterized in that** the stripline resonator (40) has a quality Q between 50 and 400, in particular between 80 and 300.

7. Sensor element according to at least one of claims 1 to 6, **characterized in that** the stripline resonator (40) is designed for the excitation of spin resonance signals with a frequency between 1 GHz and 100 GHz, preferably between 5 GHz and 85 GHz, and particularly preferably between 15 GHz and 50 GHz.

8. Sensor element according to at least one of claims 1 to 7, **characterized in that** the stripline resonator (40) is arranged in the air gap parallel and spaced apart from a metallized shielding element (100), in order to reduce radiation losses of the resonator.

9. Sensor element according to at least one of claims 1 to 8, **characterized in that** the sensor element (30) is designed and configured for the testing of an electron spin resonance feature or a ferromagnetic or ferrimagnetic resonance feature.

10. Inspection device (20) for the testing of flat data carriers, in particular banknotes, with a sensor element (30) according to one of claims 1 to 9 and with a transport device, which introduces the flat data carriers to be tested along a transport path (14) into the air gap of the magnetic core or guides them through the air gap of the magnetic core.

11. Inspection device (20) according to claim 10, **characterized in that** the transport device is designed and configured for a fast-running transport of the flat data carriers to be tested along the transport path (14).

12. Inspection device (20) according to claim 10 or 11, **characterized in that** the transport device is designed and configured to guide the flat data carriers to be tested along a transport path (14) at a small distance above the top side of the stripline resonator (40).

13. Inspection device (20) according to at least one of claims 10 to 12, **characterized in that** the sensor element (30) according to claim 8 is equipped with a shielding element (100), and the transport device is designed and configured to guide the flat data carriers to be tested along a transport path (14) in a slot between the stripline resonator (40) and the shielding element (100).

14. Inspection device (20) according to at least one of claims 10 to 13, **characterized in that** the inspection device has a signal source (22, 23) for a pulsed actuation of the stripline resonator (40) and/or for operation of the stripline resonator (40) in the Rapid-Scan method and/or in the CW method.

15. Method for testing a flat data carrier (10) with a spin resonance feature (12) by means of a sensor element (30), in which the following steps are performed:

   - Providing the flat data carrier (10);
   - Introducing the flat data carrier (10) into an air gap of a magnetic core of the sensor element (30);
   - Exciting the spin resonance feature (12) of the flat data carrier (10) by a stripline resonator (40) of the sensor element (30) arranged in the air gap of the magnetic core;
   - Detecting a measurement signal (S), which is characteristic for the spin resonance feature (12), by the stripline resonator (40); and
   - Testing the flat data carrier (10) on the basis of the detected measurement signal (S).

**Revendications**

1. Élément capteur (30) pour la vérification d'un support de données plan (10), en particulier d'un billet de banque, avec une caractéristique de résonance de spin (12), avec

 - un noyau magnétique (34) avec un entrefer, dans lequel le support de données plan (10) peut être introduit pour la vérification,
 - un élément pour la génération d'un flux magnétique statique dans l'entrefer, et
 - un résonateur (32) pour l'excitation de la caractéristique de résonance de spin du support devant être vérifié,

 **caractérisé en ce que**

 - le résonateur est formé par un résonateur à ligne à ruban (40) disposé dans l'entrefer du noyau magnétique, qui présente un support plan (42) avec une face supérieure (44-O), sur la face supérieure (44-O) étant disposée une structure conductrice (46) avec une longueur caractéristique l.

2. Élément capteur selon la revendication 1, **caractérisé en ce que** le support (42) présente une face inférieure (44-U) opposée à la face supérieure (44-O) et une surface de masse (48) disposée sur la face inférieure (44-U).

3. Élément capteur selon la revendication 1 ou 2, **caractérisé en ce que** le résonateur à ligne à ruban (40) forme un mode fondamental $\lambda/4$, un mode fondamental $\lambda/2$ ou un mode fondamental $\lambda$.

4. Élément capteur selon au moins l'une des revendications 1 à 3, **caractérisé en ce que** le résonateur à ligne à ruban (40) comprend, en tant que structure conductrice, une structure rectangulaire, une structure annulaire avec contour extérieur circulaire ou elliptique, une structure en forme de disque, une structure de secteurs annulaires avec bords extérieurs arrondis ou elliptiques, ou une structure avec une forme triangulaire ou polygonale.

5. Élément capteur selon au moins l'une des revendications 1 à 4, **caractérisé en ce que** le résonateur à ligne à ruban (40) est conçu et agencé, avec sa longueur caractéristique l, pour la vérification de la caractéristique de résonance de spin du support de données dans un mode spatial supérieur du champ d'excitation, en particulier le deuxième ou le troisième mode du champ d'excitation.

6. Élément capteur selon au moins l'une des revendications 1 à 5, **caractérisé en ce que** le résonateur à ligne à ruban (40) présente une qualité Q comprise entre 50 et 400, en particulier entre 80 et 300.

7. Élément capteur selon au moins l'une des revendications 1 à 6, **caractérisé en ce que** le résonateur à ligne à ruban (40) est conçu pour l'excitation de signaux de résonance de spin à une fréquence entre 1 GHz et 100 GHz, de préférence entre 5 GHz et 85 GHz, et particulièrement de préférence entre 15 GHz et 50 GHz.

8. Élément capteur selon au moins l'une des revendications 1 à 7, **caractérisé en ce que** le résonateur à ligne à ruban (40) est disposé dans l'entrefer parallèlement et à distance d'un élément d'écran métallisé (100), afin de réduire des pertes de rayonnement du résonateur.

9. Élément capteur selon au moins l'une des revendications 1 à 8, **caractérisé en ce que** l'élément capteur (30) est conçu et agencé pour la vérification d'une caractéristique de résonance de spin électronique ou d'une caractéristique de résonance ferromagnétique ou ferrimagnétique.

10. Dispositif de vérification (20) pour la vérification de supports de données plans, en particulier des billets de banque, avec un élément capteur (30) selon l'une des revendications 1 à 9 et avec un dispositif de transport, qui introduit les supports de données plans à vérifier le long d'un trajet de transport (14) dans l'entrefer du noyau magnétique ou les fait passer à travers l'entrefer du noyau magnétique.

11. Dispositif de vérification (20) selon la revendication 10, **caractérisé en ce que** le dispositif de transport est conçu et agencé pour un transport à fonctionnement rapide des supports de données plans à vérifier le long du trajet de transport (14).

12. Dispositif de vérification (20) selon la revendication 10 ou 11, **caractérisé en ce que** le dispositif de transport est conçu et agencé pour faire passer les supports de données plans à vérifier le long d'un trajet de transport (14) à une faible distance au-dessus de la face supérieure du résonateur à ligne à ruban (40).

13. Dispositif de vérification (20) selon au moins l'une des revendications 10 à 12, **caractérisé en ce que** l'élément capteur (30) selon la revendication 8 est équipé d'un élément d'écran (100), et **en ce que** le dispositif de transport est conçu et agencé pour faire passer les supports de données plans à vérifier le long d'un trajet de transport (14) dans une fente entre le résonateur à ligne à ruban (40) et l'élément d'écran (100).

14. Dispositif de vérification (20) selon au moins l'une des revendications 10 à 13, **caractérisé en ce que** le dispositif de vérification présente une source de signal (22, 23) pour une commande pulsée du résonateur à ligne à ruban (40) et/ou pour un fonctionnement du résonateur à ligne à ruban (40) selon le procédé Rapid-Scan et/ou selon le procédé CW.

15. Procédé de vérification d'un support de données plan (10) avec une caractéristique de résonance de spin (12) au moyen d'un élément capteur (30), dans lequel les étapes suivantes sont effectuées :

   - Mise à disposition du support de données plan (10);
   - Introduction du support de données plan (10) dans un entrefer d'un noyau magnétique de l'élément capteur (30);
   - Excitation de la caractéristique de résonance de spin (12) du support de données plan (10) par un résonateur à ligne à ruban (40) de l'élément capteur (30) disposé dans l'entrefer du noyau magnétique;
   - Détection d'un signal de mesure (S), lequel est caractéristique pour la caractéristique de résonance de spin (12), par le résonateur à ligne à ruban (40); et
   - Vérification du support de données plan (10) sur la base du signal de mesure (S) détecté.

Fig. 1

Fig. 2

Fig. 3

Fig. 4

Fig. 5

(a)                    (b)

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5149946 A